(19) Europäisches Patentamt
European Patent Office
Office européen des brevets

(11) **EP 1 704 647 B1**

(12) **EUROPEAN PATENT SPECIFICATION**

(45) Date of publication and mention
of the grant of the patent:
**20.03.2019 Bulletin 2019/12**

(51) Int Cl.:
**H03M 13/15** [(2006.01)]

(21) Application number: **04813340.9**

(22) Date of filing: **08.12.2004**

(86) International application number:
**PCT/US2004/041011**

(87) International publication number:
**WO 2005/069775 (04.08.2005 Gazette 2005/31)**

(54) **A METHOD OF REED-SOLOMON ENCODING AND DECODING**

VERFAHREN ZUR REED-SOLOMON-CODIERUNG UND -DECODIERUNG

PROCEDE DE CODAGE ET DECODAGE REED-SOLOMON

(84) Designated Contracting States:
**AT BE BG CH CY CZ DE DK EE ES FI FR GB GR HU IE IS IT LI LT LU MC NL PL PT RO SE SI SK TR**

(30) Priority: **15.01.2004 US 536509 P**

(43) Date of publication of application:
**27.09.2006 Bulletin 2006/39**

(73) Proprietor: **Qualcomm Incorporated**
**San Diego, CA 92121 (US)**

(72) Inventors:
• **IANCU, Daniel**
**Pleasantville, NY 10570 (US)**
• **MOUDGILL, Mayan**
**White Plains, NY 10607 (US)**
• **GLOSSNER, John**
**Carmel, NY 10512 (US)**

(74) Representative: **Strehl Schübel-Hopf & Partner**
**Maximilianstrasse 54**
**80538 München (DE)**

(56) References cited:
US-A- 4 763 332      US-B1- 6 263 470
US-B1- 6 327 690      US-B1- 6 360 348

• HASAN M A ET AL: "ALGORITHMS AND ARCHITECTURES FOR THE DESIGN OF A VLSI REED-SOLOMON CODEC" REED-SOLOMON CODES AND THEIR APPLICATIONS, 1994, pages 60-107, XP002055402

• R. E. BLAHUT: "Theory and Practice of error control codes" 1983, ADDISON-WESLEY , XP002427602 * page 249 *
• SHU-LIN, D. J. CONSTELLO: "error control coding: fundamentals and applications" 1983, PRENTICE-HALL , XP002427603 * page 147 - page 148 *
• MAMIDI, S.; SCHULTE, M.J.; IANCU, D.; IANCU, A.; GLOSSNER, J.;: "Instruction set extensions for Reed-Solomon encoding and decoding" MAMIDI, S.; SCHULTE, M.J.; IANCU, D.; IANCU, A.; GLOSSNER, J.;, 25 May 2005 (2005-05-25), XP002425607
• PEDRO NUNEZ: "LIBRO DE ALGEBRA EN ARITHMETICA Y GEOMETRIA" INTERNET ARTICLE, 1567, XP002425608
• LUENEBURG: "Synthetic division" INTERNET ARTICLE, [Online] 26 November 1998 (1998-11-26), XP002425609 Retrieved from the Internet: URL:http://202.38.126.65/mirror/archives.m ath.utk.edu/hypermail/historia/nov98/0242. html> [retrieved on 2007-03]
• ROHITHA GOONATILAKE: "A Generalization of Synthetic Division" INTERNET ARTICLE, [Online] September 2003 (2003-09), XP002425610 Retrieved from the Internet: URL:http://www.pims.math.ca/pi/issue7/page 13-16.pdf> [retrieved on 2007-03]
• SHU-LIN, D. J. COSTELLO: "Error control coding: fundamentals and applications", 1983, Prentice-Hall pages 90-91,

• **C.K.P.Clarke: "https://downloads.bbc.co.uk/rd/pubs/whp/whp-pdf-files/WHP031.pdf", internet article, July 2002 (2002-07), Retrieved from the Internet: URL:https://downloads.bbc.co.uk/rd/pubs/whp/whp-pdf-files/WHP031.pdf [retrieved on 2017-08-08]**

**Description**

BACKGROUND AND SUMMARY OF THE DISCLOSURE

The present disclosure relates generally to polynomial-generated error-correcting encoding and decoding and, more specifically, to Reed-Solomon encoding and error detection and correction techniques.

Reed-Solomon coding and decoding schemes are used in many communication systems, such as satellites, modems, audio compact discs and wireless telephones. Each communication system has a different set of values for the parameters which define the Reed-Solomon code. Reed-Solomon encoders/decoders use Galois Field (GF) arithmetic to map blocks of communication into larger blocks. Each block corresponds to an oversimplified polynomial based on the input block.

The technology is explained in Shu-Lin, D.J. Costello: "Error control coding: fundamentals and applications", Prentice-Hall, pages 90-91, 1983, and C.K.P. Clarke: "Reed Solomon error correction", BBC R&D White Paper WHP 031, 2002.

As implemented in hardware, the Reed-Solomon encoder/decoder requires a substantial number of logic gates and other hardware. Many efforts have been directed to reducing the amount of hardware by, for example, parallel processing and reducing the arithmetic representation of the processes.

Reed-Solomon decoders, specific to various communication systems, have been implemented in dedicated hardware blocks because of the computational complexity and low power requirements. See, for example, R. E. Blahut's "Theory and practice of error control codes," Addison-Wesley, 1984; and S. B. Wicker's "Error control systems for digital communication and storage," Prentice Hall, Inc., 1995.

The invention solving the above difficulties is defined by the appended claims and includes a Reed-Solomon encoding method in accordance with claim 1.

Further disclosed in the present specification are method steps for Reed-Solomon decoding. The entire encoding and decoding method of the present disclosure is executed in software without employing Galois field polynomial division. The decoding method is also performed in software by direct solving of the required system equations for both the error locators and error magnitude.

A Reed-Solomon encoder method of the present disclosure includes appending $N$ zeros to a data block and performing a successive Horner reduction of the polynomial $P(x) = \sum_{i=0}^{2^n-1} a_i x^i$ whose coefficients are the data of the data block plus the zeros, the reductions producing a plurality of remainders $\beta^{(i)}$ for $i = 0$ to $N-1$. The remainders $\beta^{(i)}$ are multiplied by corresponding polynomial coefficients $D^{(i)}(x)$, which are stored in a memory and sum all of the resulting products $\sum_{i=0}^{N-1} \beta^{(i)} D^{(i)}(x)$. The sum of the products represent remainder coefficients of a polynomial, which is the division of the polynomial $P(x)$ by a generator polynomial $g(x) = \prod_{i=0}^{N-1} (x + \alpha^i)$. The sum of the products is appended to the data block as parity symbols to form a codeword. The method is performed in software.

A Reed-Solomon decoder method of the present disclosure for decoding a codeword which includes data symbols and parity symbols includes calculating syndromes as the dot product of the codeword with syndrome vectors stored in memory, the syndrome vectors being the coefficients of the polynomials $\Sigma_i = \sum_{k=0}^{2^n-1} x^k (\alpha^k)^i$, where the number of syndrome vectors $i$ equals the number of parity symbols in the codeword. If the syndromes equal 0, decode the codeword by merely removing the parity symbols. If the syndromes do not equal 0, correct the codeword by forming and solving an error locator polynomial for error locations, forming and solving an error magnitude polynomial for error magnitudes at the locations and correcting the error in the codeword. The codeword is decoded by removing the parity symbols. The method is performed in software.

These and other aspects of the present disclosure will become apparent from the following detailed description of the disclosure, when considered in conjunction with accompanying drawings.

BRIEF DESCRIPTION OF DRAWINGS

Figure 1 is a flow chart of a Reed-Solomon encoder according to the principles of the present disclosure.
Figure 2 is a flow chart of a Reed-Solomon decoder according to the principles of the present disclosure.

DETAILED DESCRIPTION OF THE PREFERRED EMBODIMENTS

ENCODER

Encoder schemes generally take a block of data consisting of data symbols and adds parity symbols to produce what is referred to as a codeword. In the Reed-Solomon encoding system, the parity symbols are the remainder of the division of two polynomials.

$$P(x) = \sum_{i=0}^{2^n-1} a_i x^i$$

The first polynomial $\qquad$ is a data block of length $2^n$ in a Galois field GF($2^n$). The second polynomial

$$g(x) = \prod_{i=0}^{N-1} (x + \alpha^i)$$

is the generator polynomial in GF($2^n$). $\alpha^i$ and $a_i$ are field elements in GF($2^n$).

In order to calculate the remainder of the polynomial division in GF($2^n$) by using GF multiplications and additions only, the equation is simplified and portions are pre-calculated or predetermined and stored in memory. This provides a software implementation and is adaptable or reconfigurable.

$$g(x) = \prod_{j=i}^{N-1} (x + \alpha^j)$$

Suppose $Q^{(i)}$ are the quotients of the division of data $P(x)$ with the generator polynomials

For:

$i=0$

$$\frac{P(x)}{x + \alpha^0} = Q^{(0)} + \frac{\beta^{(0)}}{x + \alpha^0}$$

$i=1$

$$\frac{P(x)}{(x + \alpha^0)(x + \alpha^1)} = Q^{(1)} + \frac{\beta^{(0)}}{(x + \alpha^0)(x + \alpha^1)} + \frac{\beta^{(1)}}{x + \alpha^1}$$

$i=2$

$$\frac{P(x)}{(x + \alpha^0)(x + \alpha^1)(x + \alpha^2)} = Q^{(2)} + \frac{\beta^{(0)}}{(x + \alpha^0)(x + \alpha^1)(x + \alpha^2)} + \frac{\beta^{(1)}}{(x + \alpha^1)(x + \alpha^2)} + \frac{\beta^{(2)}}{(x + \alpha^2)}$$

In general, for $i=N-1$

$$\frac{P(x)}{\prod_{i=0}^{N-1}(x + \alpha^i)} = Q^{(N-1)} + \frac{\beta^{(0)}}{\prod_{i=0}^{N-1}(x + \alpha^i)} + \frac{\beta^{(1)}}{\prod_{i=1}^{N-1}(x + \alpha^i)} + ... + \frac{\beta^{(N-1)}}{\prod_{i=N-1}^{N-1}(x + \alpha^i)}$$

The remainder of the above equation after simple calculations can be written as:

$$\frac{\beta^{(0)}}{\prod\limits_{i=0}^{N-1}(x+\alpha^i)}+\frac{\beta^{(1)}}{\prod\limits_{i=1}^{N-1}(x+\alpha^i)}+...+\frac{\beta^{(N-1)}}{\prod\limits_{i=N-1}^{N-1}(x+\alpha^i)}=\sum\limits_{i=0}^{N-1}\frac{\beta^{(i)}\prod\limits_{k=0}^{N-1}(x+\alpha^k)}{\prod\limits_{j=i}^{N-1}(x+\alpha^j)}=\sum\limits_{i=0}^{N-1}\frac{\beta^{(i)}\prod\limits_{k=0}^{N-i-1}(x+\alpha^k)}{}$$

The coefficients $\beta^{(i)}$ are the remainders of the successive Horner reduction of $P(x)$, as illustrated in Table 1.

Table 1: Successive Horner reduction of the polynomial $P(x)$ with $\alpha^j$.

| $a_{n-1}$ | $a_{n-2}$ | ... $a_2$ | $a_1$ | $a_0$ | $\alpha^0$ |
|---|---|---|---|---|---|
| $a_{n-1}$ | $a_{n-1}\,\alpha^0 + a_{n-2}$ | $(a_{n-1}\,\alpha^0 + a_{n-2})+ a_{n-3}$ | ... | $\beta^{(0)}$ | $\alpha^1$ |
| $a_{n-1}$ | $(a_{n-1}\,\alpha^0 + a_{n-2})\,\alpha^1$ | | $\beta^{(1)}$ | | $\alpha^2$ |
| ... | | | | | |
| $a_{n-1}$ | $\beta^{(N-1)}$ | | | | $\alpha^N$ |

$$D^{(i)}(x)=\prod\limits_{k=0}^{N-i-1}(x+\alpha^k)$$

The $N$ polynomials are predetermined and stored in the memory. The remainder coefficients $\beta^{(i)}$ are multiplied by corresponding polynomial coefficients $D^{(i)}(x)$, from memory. The sum of all the resulting

$$\sum\limits_{i=0}^{N-1}\beta^{(i)}\,D^{(i)}(x)$$

products represent remainder coefficients of a polynomial, which is the division of the data polynomial $P(x)$ by a generator polynomial $g(x)$.

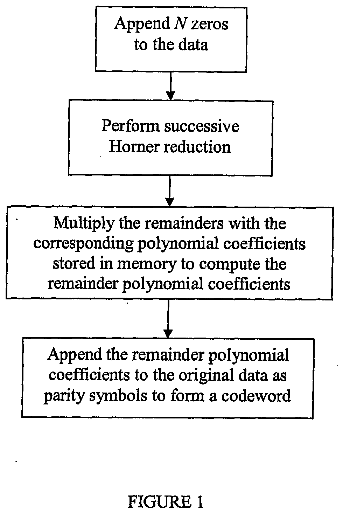

The encoding method is illustrated in Figure 1 as appending $N$ zeros to the data. Next, a Horner reduction of the polynomials of the $P(x)$, which are the coefficients of the data of the data block plus the zeros, is performed. Then, the remainders of the reduction are multiplied with the corresponding polynomial coefficients $D(x)$ stored in memory in order to compute the remainder polynomial coefficient. The remainder polynomial coefficients are appended to the original data to form a codeword.

A specific example is as follows:

The RS(256, 240) is a codeword of length 256 including 240 data symbols and 16 parity symbols.
The given coefficients of the generator polynomial $g(x)$ are:
1,59,13,104,189,68,209,30,8,163,65,41,229,98,50,36,59
The given roots $\{\alpha^i\}$ of the generator polynomial $g(x)$ are:
1,2,4,8,16,32,64,128,29,58,116,232,205,135,19,38
The resulting pre-calculated and stored $D^{(i)}(x)$ polynomial coefficients are:

```
1
1    1
1    3    2
1    7    14   8
1    15   54   120  64
1    31   198  63   147  116
1    63   1    218  32   227  38
1    127  122  154  164  11   68   117
1    255  11   81   54   239  173  200  24
1    226  207  158  245  235  164  232  197  37
1    216  194  159  111  199  94   95   113  157  193
1    172  130  163  50   123  219  162  248  144  116  160
1    68   119  67   118  220  31   7    84   92   127  213  97
1    137  73   227  17   177  17   52   13   46   43   83   132  120
1    14   54   114  70   174  151  43   158  195  127  166  210  234  163
```

(continued)

| 1 | 29 | 196 | 111 | 163 | 112 | 74 | 10 | 105 | 105 | 139 | 132 | 151 | 32 | 134 | 26 |
|---|----|-----|-----|-----|-----|----|----|-----|-----|-----|-----|-----|----|-----|----|

The data with 16 appended zeros *P(x)* are:
131,244,241,21,70,0,0,0,0,0,0,0,0,0,0,0,0,0,0,0 The remainder coefficients $\{\beta^{(i)}\}$ from the successive Horner reduction of *P(x)* are:
213,60,145,132,17,44,214,94,5,26,13,78,185,165,215,97
After Galois multiplication of $D^{(i)}(x)$ and $\{\beta^{(i)}\}$ and summing, the parity symbols are:
97,94,173,51,172,26,65,42,149,22,149,229,37,55,117,61
The parity symbols are appended to the data block and the codeword is:
131,244,241,21,70,97,94,173,51,172,26,65,42,149,22,149,229,37,55,117,61

DECODER

The received codeword is represented as:

$$C(x) = \sum_{i=0}^{n-1} c_i x^i$$

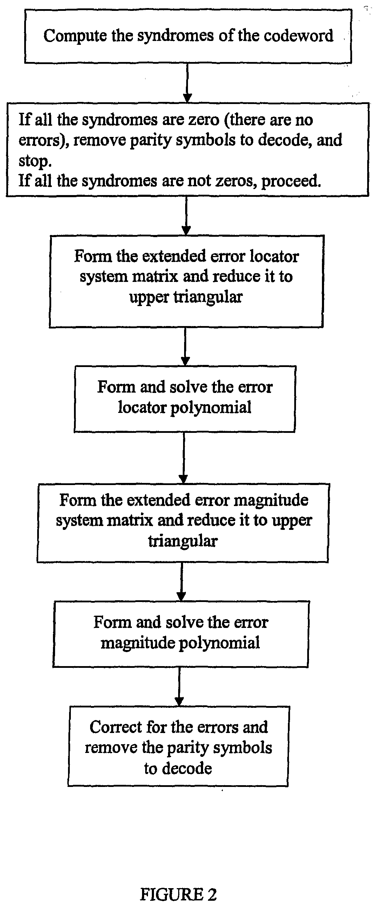

Instead of checking the validity of the code word by decoding the data part of the received codeword and comparing the parity bits to the received parity bits, the decoding starts directly by calculating the syndromes, as shown in Figure 2.

The syndrome calculation is described the formula:

$$S_i = \mathbf{C}^{\mathbf{T}} \mathbf{\Sigma}_i \qquad i = (1,2...N-1)$$

Where C is a vector whose entries are the coefficients of the codeword polynomial $C(x)$, and $\Sigma_i$ are the syndrome vectors whose entries are the coefficients of the following polynomial:

$$\mathbf{\Sigma}_i = \sum_{k=0}^{2^n-1} x^k (\alpha^k)^i$$

where the number of syndrome vectors N equals the number of parity symbols in the codeword, and the size of the syndrome vectors each equals the size of the codeword. The syndrome vectors are also stored in the memory.

If the syndromes equal 0, the codeword is decoded by merely removing the parity symbols, and the decoding process is stopped. If the syndromes do not equal 0, the codeword is corrected by forming and solving an error locator polynomial for error locations, forming and solving an error magnitude polynomial for error magnitudes at the locations and correcting the error in the codeword. The codeword is corrected for errors by subtracting (same as adding in GF) the error vectors from the received (corrupted) codeword. The codeword is decoded by removing the parity symbols. This is shown in Figure 2. The decoding algorithm is also performed in software using the Peterson-Gorenstein-Zierler method.

An example of the processing if the syndromes are different from zero includes forming the syndrome matrix equation:

$$
\begin{pmatrix}
S_0 & S_1 & S_2 & \dots & S_{\frac{N}{2}-2} & S_{\frac{N}{2}-1} \\
S_1 & S_2 & S_3 & \dots & S_{\frac{N}{2}-1} & S_{\frac{N}{2}} \\
S_2 & S_3 & S_4 & \dots & S_{\frac{N}{2}} & S_{\frac{N}{2}+1} \\
. & . & . & & . & . \\
. & . & . & \dots & . & . \\
. & . & . & & . & . \\
S_{\frac{N}{2}-2} & S_{\frac{N}{2}-1} & S_{\frac{N}{2}} & \dots & S_{N-2} & S_{N-1} \\
S_{\frac{N}{2}-1} & S_{\frac{N}{2}} & S_{\frac{N}{2}+1} & \dots & S_{N-3} & S_{N-2}
\end{pmatrix}
\begin{pmatrix}
\Lambda_{\frac{N}{2}-1} \\
\Lambda_{\frac{N}{2}-2} \\
\Lambda_{\frac{N}{2}-3} \\
. \\
. \\
. \\
\Lambda_1 \\
\Lambda_0
\end{pmatrix}
=
\begin{pmatrix}
S_{\frac{N}{2}} \\
S_{\frac{N}{2}+1} \\
S_{\frac{N}{2}+2} \\
. \\
. \\
S_{N-2} \\
S_{N-1}
\end{pmatrix}
$$

In the previous equation, $\Lambda_i$ are the coefficients of the error locator polynomial.

In GF, the extended system matrix can be easily transformed in a upper triangular form by using Gauss reduction, thus avoiding in this way the matrix inversion.

$$
\begin{pmatrix}
1 & \Xi_1 & \Xi_2 & \dots & \Xi_{\frac{N}{2}-2} & \Xi_{\frac{N}{2}-1} \\
0 & 1 & \Xi_3 & \dots & \Xi_{\frac{N}{2}-1} & \Xi_{\frac{N}{2}} \\
0 & 0 & 1 & \dots & \Xi_{\frac{N}{2}} & \Xi_{\frac{N}{2}+1} \\
. & . & . & & . & . \\
. & . & . & \dots & . & . \\
. & . & . & & . & . \\
0 & 0 & 0 & \dots & 1 & \Xi_{N-1} \\
0 & 0 & 0 & \dots & 0 & 1
\end{pmatrix}
\cdot
\begin{pmatrix}
\Lambda_{\frac{N}{2}-1} \\
\Lambda_{\frac{N}{2}-2} \\
\Lambda_{\frac{N}{2}-3} \\
. \\
. \\
\Lambda_1 \\
\Lambda_0
\end{pmatrix}
=
\begin{pmatrix}
\Xi_{\frac{N}{2}} \\
\Xi_{\frac{N}{2}+1} \\
\Xi_{\frac{N}{2}+2} \\
. \\
. \\
\Xi_{N-2} \\
\Xi_{N-1}
\end{pmatrix}
$$

The rank of the system will be the Euclidian trace. Now, the system equation can be easily solved: $\Lambda_0 = \Xi_{N-1}$, $\Lambda_1 = \Xi_{N-1}\Lambda_0 + \Xi_{N-2}$, and so on.

$$
\Lambda(x) = \sum_{i=0}^{m} \Lambda_i x^i
$$

The error locator polynomial is solved using Chien search. The inverse of the solution of the error locator polynomial represent the position for the errors, where m is equal to or less than $N/2$.

The error magnitudes for m errors are computed using the error magnitude system equation:

$$
\begin{pmatrix}
\dfrac{1}{\Lambda_{i_0}} & \dfrac{1}{\Lambda_{i_1}} & \dots & \dfrac{1}{\Lambda_{i_{m-1}}} \\
\dfrac{1}{\Lambda_{i_0}^2} & \dfrac{1}{\Lambda_{i_1}^2} & \dots & \dfrac{1}{\Lambda_{i_{m-1}}^2} \\
. & . & & . \\
. & . & \dots & . \\
. & . & & . \\
\dfrac{1}{\Lambda_{i_0}^m} & \dfrac{1}{\Lambda_{i_1}^m} & \dots & \dfrac{1}{\Lambda_{i_{m-1}}^{i_{m-1}}}
\end{pmatrix}
\begin{pmatrix}
e_{i_0} \\
e_{i_1} \\
. \\
. \\
e_{i_{m-1}}
\end{pmatrix}
=
\begin{pmatrix}
S_0 \\
S_1 \\
. \\
. \\
S_{m-1}
\end{pmatrix}
$$

The error magnitude polynomial is solved in a similar way as the error locator polynomial resulting the magnitudes of the errors $e_{i_j}$, $i_j=1,2,\dots m\text{-}1$.

A specific example is as follows:

The computed syndromes are:

1,33,131,24,136,153,216,49,234,81,233,87,70,166,106,55

The extended upper triangular error locator system matrix formed is:

| 1 | 33 | 131 | 24 | 136 | 153 | 216 | 49 | 234 |
|---|----|-----|----|-----|-----|-----|----|-----|
| 0 | 1 | 30 | 44 | 204 | 95 | 222 | 151 | 44 |
| 0 | 0 | 1 | 80 | 44 | 105 | 181 | 142 | 18 |
| 0 | 0 | 0 | 1 | 127 | 71 | 56 | 118 | 17 |
| 0 | 0 | 0 | 0 | 1 | 226 | 77 | 213 | 139 |
| 0 | 0 | 0 | 0 | 0 | 1 | 214 | 176 | 28 |
| 0 | 0 | 0 | 0 | 0 | 0 | 1 | 76 | 21 |
| 0 | 0 | 0 | 0 | 0 | 0 | 0 | 1 | 246 |

The solutions of error locator polynomial are:
246,66,232,128,185,202,17,25
and the errors are:
1,2,3,4,5,6,20,21

Although the present disclosure has been described and illustrated in detail, it is to be clearly understood that this is done by way of illustration and example only and is not to be taken by way of limitation. The scope of the present disclosure is to be limited only by the terms of the appended claims.

**Claims**

1. A Reed-Solomon encoding method comprising:

   appending $N$ zeros to a data block to generate a polynomial $P(x) = \sum_{i=0}^{2^n-1} a_i x^i$ , wherein the coefficients $a_i$ are data of the data block including the appended $N$ zeros;

   successively performing a Horner reduction with $\alpha^i$ of the polynomial $P(x)$ to produce a plurality of remainders $\beta^{(i)}$, wherein each remainder $\beta^{(i)}$ is produced by Horner reduction with polynomial $x + \alpha^i$ thereby successively reducing $P(x)$ by $x + \alpha^i$, wherein $i = 0$ to $N$-1;

   multiplying the remainders $\beta^{(i)}$ with corresponding polynomials $D^{(i)}(x) = \prod_{k=0}^{N-i-1}(x + \alpha^k)$ to generate polynomials $\beta^{(i)}D^{(i)}(x)$, wherein the coefficients of $D^{(i)}(x)$ are stored in a memory, and calculating the sum of all the generated polynomials $\sum_{i=0}^{N-1} \beta^{(i)}D^{(i)}(x)$ representing the remainder coefficients of a division of the polynomial $P(x)$ by a generator polynomial $g(x) = \prod_{i=0}^{N-1}(x + \alpha^i)$ ; and

   appending the remainder coefficients to the data block as parity symbols to form a codeword.

2. The method of claim 1, wherein the method is performed in software.

3. A communication device including an encoder configured to perform the method of claim 1.

4. The communication device of claim 3, containing software configured to perform the method of claim 1.

5. A system comprising an encoder configured to perform a Reed-Solomon encoding method in accordance with claim 1, and a decoder configured to perform a Reed-Solomon decoding method of decoding a codeword that includes data symbols and parity symbols generated by a Reed-Solomon encoding method in accordance with claim 1.

6. The system of claim 5, containing software configured to perform said Reed-Solomon decoding method.

7. The system of claim 5, wherein said decoder is configured to calculate syndromes as a product of the codeword with syndrome vectors stored in a memory, wherein the size of the syndrome vectors each equals the size of the codeword.

**Patentansprüche**

1. Reed-Solomon-Codierverfahren umfassend:

   Anhängen von *N* Nullen an einen Datenblock, um ein Polynom $P(x) = \sum_{i=0}^{2^n-1} a_i x^i$ zu erzeugen, wobei die Koeffizienten $a_i$ Daten des Datenblocks einschließlich der angehängten *N* Nullen sind;

   fortschreitendes Ausführen einer Horner-Reduktion mit $\alpha^i$ des Polynoms *P(x)*, um mehrere Reste $\beta^{(i)}$ zu erzeugen, von denen jeder Rest $\beta^{(i)}$ durch Horner-Reduktion mit dem Polynom $x + \alpha^i$ erzeugt wird, wodurch *P(x)* fortschreitend um $x + \alpha^i$ reduziert wird, wobei *i = 0* bis *N-1* ist;

   Multiplizieren der Reste $\beta^{(i)}$ mit entsprechenden Polynomen $D^{(i)}(x)$ $= \prod_{k=0}^{N-i-1}\left(x + \alpha^k\right)$, um Polynome $\beta^{(i)}D^{(i)}(x)$ zu erzeugen, wobei die Koeffizienten von $D^{(i)}(x)$ in einem Speicher gespeichert sind, und Berechnen der Summe

   $$\sum_{i=0}^{N-1} \beta^{(i)}D^{(i)}(x),$$

   aller erzeugten Polynome die die Restkoeffizienten einer Division des Polynoms *P(x)* durch ein Generatorpolynom $g(x) = \prod_{i=0}^{N-1}(x + \alpha^i)$ darstellt; und

   Anhängen der Restkoeffizienten als Paritätssymbole an den Datenblock, um ein Codewort zu bilden.

2. Verfahren nach Anspruch 1, wobei das Verfahren in Software ausgeführt wird.

3. Kommunikationsvorrichtung mit einem Encoder, der zur Ausführung des Verfahrens nach Anspruch 1 eingerichtet ist.

4. Kommunikationsvorrichtung nach Anspruch 3 mit Software, die zur Ausführung des Verfahrens nach Anspruch 1 eingerichtet ist.

5. System mit einem Encoder, der zur Ausführung eines Reed-Solomon-Codierverfahrens nach Anspruch 1 eingerichtet ist, sowie einem Decoder, der zur Ausführung eines Reed-Solomon-Decodierverfahrens zum Decodieren eines Codeworts eingerichtet ist, das Datensymbole und Paritätssymbole enthält, die von einem Reed-Solomon-Codierverfahren nach Anspruch 1 erzeugt sind.

6. System nach Anspruch 5 mit Software, die zur Ausführung des Reed-Solomon-Decodierverfahrens eingerichtet ist.

7. System nach Anspruch 5, wobei der Decoder eingerichtet ist, Syndrome als Produkt des Codeworts mit Syndromvektoren zu erzeugen, die in einem Speicher gespeichert sind, wobei die Größe der Syndromvektoren jeweils gleich der Größe des Codeworts ist.

**Revendications**

1. Procédé de codage de Reed-Solomon comprenant :

   l'ajout de *N* zéros à un bloc de données pour générer un polynôme $P(x) = \sum_{i=0}^{2^n-1} a_i x^i$ , dans lequel les coefficients $a_i$ sont des données du bloc de données incluant les *N* zéros ajoutés ;

   l'exécution successive d'une réduction de Horner avec $\alpha^i$ du polynôme *P(x)* pour produire une pluralité de restes $\beta^{(i)}$, dans lequel chaque reste $\beta^{(i)}$ est produit par une réduction de Horner avec un polynôme $x + \alpha^i$, réduisant ainsi avec succès *P*(x) par $x + \alpha^i$, dans lequel *i = 0* à *N-1* ;

la multiplication des restes $\beta^{(i)}$ par des polynômes correspondants $D^{(i)}(x) = \prod_{k=0}^{N-i-1}\left(x+\alpha^k\right)$ pour générer des polynômes $\beta^{(i)}D^{(i)}(x)$, dans lequel les coefficients de $D^{(i)}(x)$ sont stockés dans une mémoire, et le calcul de la somme de tous les polynômes générés $\sum_{i=0}^{N-1}$, $\beta^{(i)}D^{(i)}(x)$ représentant les coefficients de restes d'une division du polynôme $P(x)$ par un polynôme générateur $g(x) = \prod_{i=0}^{N-1}(x+\alpha^i)$ ; et

l'ajout des coefficients de restes au bloc de données comme des symboles de parité pour former un mot de code.

2.  Procédé selon la revendication 1, dans lequel le procédé est exécuté dans un logiciel.

3.  Dispositif de communication incluant un encodeur configuré pour exécuter le procédé selon la revendication 1.

4.  Dispositif de communication selon la revendication 3, contenant un logiciel configuré pour exécuter le procédé selon la revendication 1.

5.  Système comprenant un encodeur configuré pour exécuter un procédé de codage de Reed-Solomon selon la revendication 1, et un décodeur configuré pour exécuter un procédé de décodage de Reed-Solomon pour décoder un mot de code qui inclut des symboles de données et des symboles de parité généré par un procédé de codage de Reed-Solomon selon la revendication 1.

6.  Système selon la revendication 5, contenant un logiciel configuré pour exécuter ledit procédé de décodage de Reed-Solomon.

7.  Système selon la revendication 5, dans lequel ledit décodeur est configuré pour calculer des syndromes comme un produit du mot de code avec des vecteurs de syndromes stockés dans une mémoire, dans lequel la taille des vecteurs de syndromes est chacune égale à la taille du mot de code.

Append *N* zeros
to the data

Perform successive
Horner reduction

Multiply the remainders with the
corresponding polynomial coefficients
stored in memory to compute the
remainder polynomial coefficients

Append the remainder polynomial
coefficients to the original data as
parity symbols to form a codeword

FIGURE 1

Compute the syndromes of the codeword

If all the syndromes are zero (there are no errors), remove parity symbols to decode, and stop.
If all the syndromes are not zeros, proceed.

Form the extended error locator system matrix and reduce it to upper triangular

Form and solve the error locator polynomial

Form the extended error magnitude system matrix and reduce it to upper triangular

Form and solve the error magnitude polynomial

Correct for the errors and remove the parity symbols to decode

FIGURE 2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **SHU-LIN, D.J. COSTELLO.** Error control coding: fundamentals and applications. Prentice-Hall, 1983, 90-91
- **C.K.P. CLARKE.** Reed Solomon error correction. *BBC R&D White Paper WHP 031,* 2002

- **R. E. BLAHUT'S.** Theory and practice of error control codes. Addison-Wesley, 1984
- **S. B. WICKER'S.** Error control systems for digital communication and storage. Prentice Hall, Inc, 1995